# EUROPEAN PATENT SPECIFICATION

(11) **EP 0 754 367 B1**
(45) Date of publication and mention of the grant of the patent: **09.09.1998**
(21) Application number: 95916070.6
(22) Date of filing: 27.03.1995
(51) Int. Cl.: H02M 1/00, H02B 1/32, H05K 5/00

(54) **ENCLOSED VALVE MEANS FOR HIGH VOLTAGE AND HIGH POWER**
GEKAPSELTE HOCHSPANNUNGS-VENTILANORDNUNG
TUBE ELECTRONIQUE A ENCEINTE POUR HAUTE TENSION ET HAUTES ENERGIES

(30) Priority: 08.04.1994 SE 9401184
(43) Date of publication of application: 22.01.1997
(73) Proprietor: ASEA BROWN BOVERI AB, 721 83 Västeras (SE)
(72) Inventor: SANDIN, Björn, S-771 60 Ludvika (SE)
(86) International application number: SE9500323
(87) International publication number: WO9528030

(56) References cited:
- EP-A- 172 554
- US-A- 4 077 057
- US-A- 4 816 980

## Description

### TECHNICAL FIELD

The present invention relates to an enclosed gas-insulated valve means for high voltage and high power, preferably for an installation for power transmission by means of high-voltage direct current, wherein
- the valve means comprises an enclosure of electrically conducting material and a semiconductor valve arranged in the enclosure,
- the semiconductor valve has a plurality of electrically series-connected power semiconductor elements and a first and a second electric main terminal,
- the main terminals are arranged at first and second, mutually opposite parts of the semiconductor valve,
- the direction between the first and second parts constitutes the main direction of the semiconductor valve, and
- the valve means is adapted for a maximum potential difference, occurring during operation, between the semiconductor valve and the enclosure which is lower at the first part than at the second part.

The invention primarily relates to a valve means for use in an installation for power transmission by means of high-voltage direct current, HVDC. However, the invention may also be applied to valve means intended for other purposes, for example for use in equipment for static reactive-power compensation in power networks.

The concept "high voltage" as used in this application relates to a valve voltage exceeding about 50 kV, and the concept "high power" relates to a power per valve which corresponds to a rated power exceeding about 100 MW in a twelve-pulse converter with valves according to the invention.

The concept "valve" in connection with converters relates to a set of one or more, controlled or uncontrolled, power semiconductor elements, such as thyristors or diodes, which from an electrical point of view function as a unit. In this application, the concept "semiconductor valve" is used in a broader sense than the concept "valve", namely, to denote a set of electrically series-connected power semiconductor components, which constitute a physical unit and which together constitute either
- a whole valve, or
- a part, for example half, of a valve, or
- two valves series-connected to each other, or
- adjoining parts of two such valves.

The concept "valve means" as used in this application means a physical unit which comprises a semiconductor valve with an enclosure, and the necessary auxiliary equipment, such as bushings and overvoltage protective means.

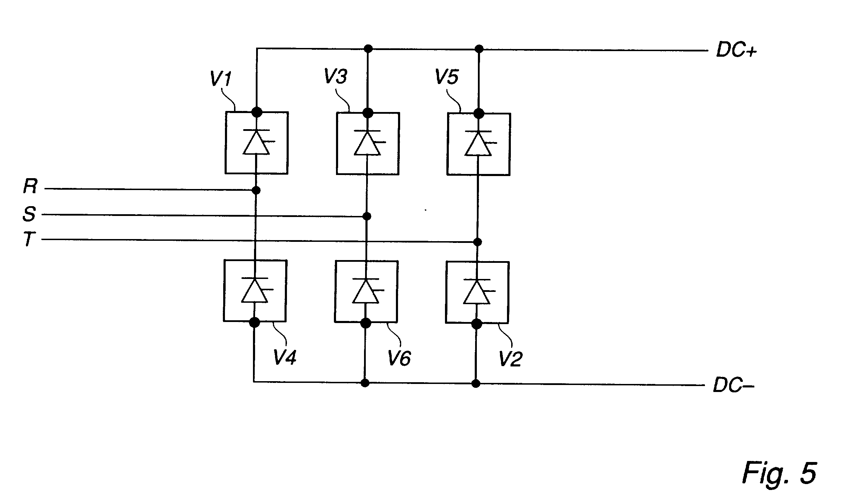

The concept "main terminal" as used in this application means an electrical connection to a valve means which is adapted to carry the load current of the means. The two connections to a conventional converter valve, for example one of the six valves in a six-pulse three-phase bridge of the kind shown in Figure 5, thus constitute the main terminals of the valve. The concept is used to distinguish the main terminals from other electrical connections to the valve, for example for control and measurement purposes.

### BACKGROUND ART

From the international patent application with publication number WO 93/17488, it is previously known, in an HVDC converter, to arrange the valves gas-insulated and enclosed for outdoor erection. For this purpose, each valve (possibly a half-valve or two series-connected half-valves) is arranged in a separate enclosure. One valve consists of a plurality of electrically series-connected semiconductor elements - thyristors or diodes. The semiconductor elements are arranged in a plurality of mechanical units - modules. In a manner known per se, each module may have a certain number of, for example six, series-connected semiconductor elements and also comprise auxiliary elements and auxiliary circuits, for example RC circuits for voltage division, inductors for limitation of the rate of change of the current, and control circuits for controlling the semiconductor elements. The modules are arranged in two layers one above the other, two and two abreast and two modules after each other in the longitudinal direction of the valve. Each module has approximately constant dimensions along the whole of its length. This will also be the case with the semiconductor valve which consists of the eight series-connected modules.

The valve is gas-insulated, and the housing in which the semiconductor valve is arranged is filled with a suitable gas, for example air, nitrogen, or SF₆ (sulphur hexafluoride). In the case of a single valve (or a half-valve) of this known type, one end of the valve is electrically connected to the housing whereas the other end is connected to a high-voltage bushing arranged in the wall of the housing. In a unit consisting of two series-connected half-valves, the point of connection of the half-valves is connected to the housing and those ends of the half-valves which are facing away from each other are connected to bushings.

A similar design of converter valves is known from the European patent specification with the publication number 0 172 554, which describes a thyristor valve in which a semiconductor valve consisting of a plurality of thyristor modules is arranged in an enclosure filled with SF₆ gas under pressure.

The advantages of the above embodiments are that the enclosures with the semiconductor valves mounted therein may be manufactured completely at the factory and that the need of valve halls is completely eliminated. However, in the valve designs used so far, the manufacture of the valves at the factory has entailed relatively large transport dimensions.

Especially at the highest occurring voltages and powers, the dimensions of the enclosures have become so large that they cannot, or can only with difficulty, be accommodated within the current loading-gauges. The large dimensions of the enclosures also entail a relatively great need of ground area for erection of the valves - usually 12 or 24 valves - which are included in a single-pole or a two-pole HVDC converter station.

### SUMMARY OF THE INVENTION

The invention aims to provide a valve means of the kind described in the introductory part of the description, the external dimensions of which are smaller than in prior art valve means of the kind referred to, and which thus makes possible considerably reduced transport problems and entails reduced demands for ground area for its erection.

According to the invention, the semiconductor valve arranged in the enclosure is designed such that it tapers from the above-mentioned "first part", where the potential difference between the valve and the enclosure is lower, towards the "second part", where the potential difference is higher. This permits, also in a parallelepipedic enclosure, the flashover distance between the semiconductor valve and the enclosure to be made increasing along the main direction of the valve from the first part towards the second part and thus be adapted to the increasing potential difference, along the main direction of the semiconductor valve, between the semiconductor valve and the enclosure. It has proved that in this way it is possible to obtain a considerable reduction of the dimensions and volumes of a valve means.

What characterizes a valve means according to the invention will become clear from the appended claims.

### BRIEF DESCRIPTION OF THE DRAWINGS

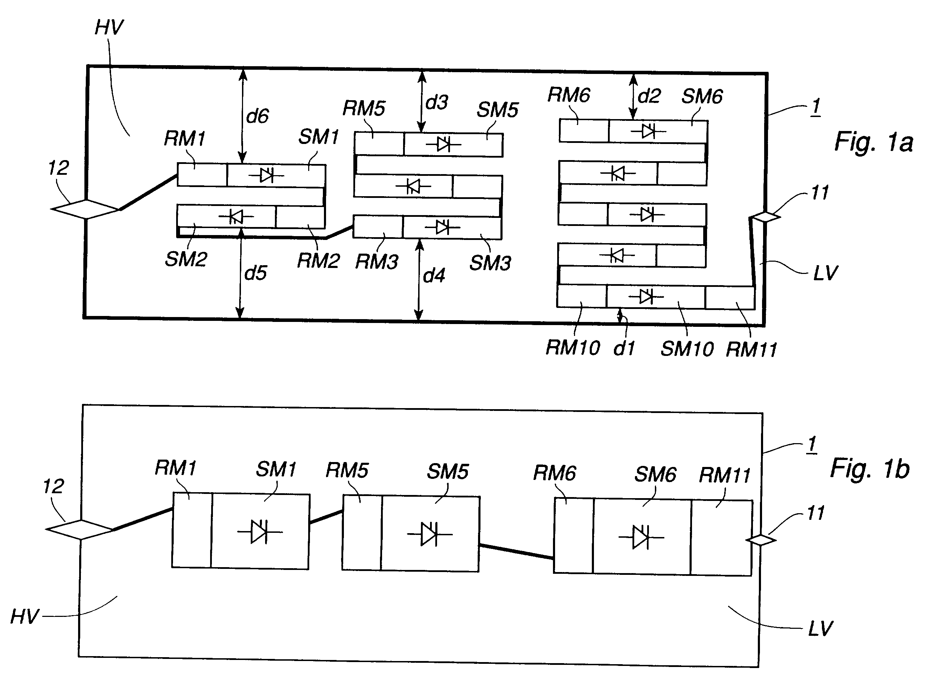

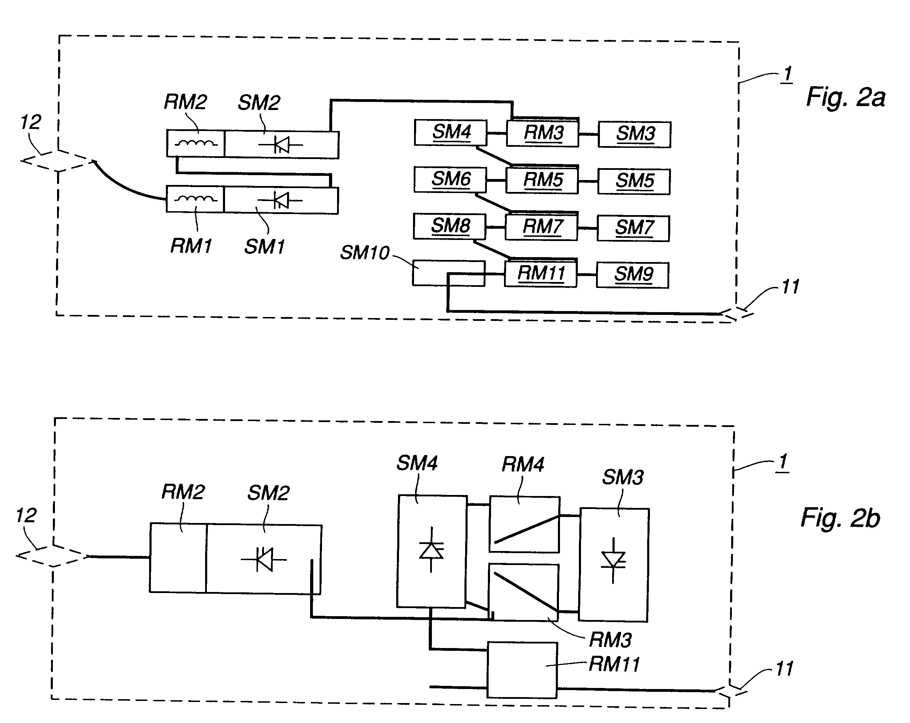

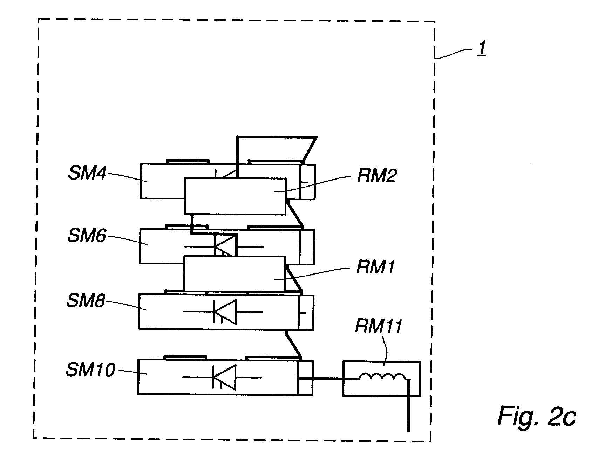

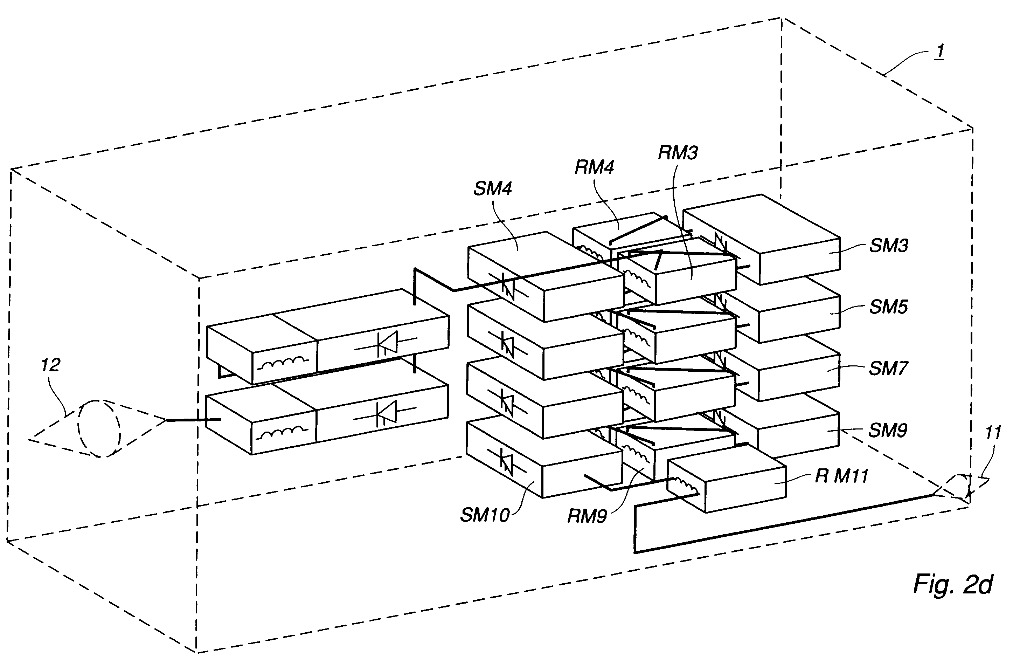

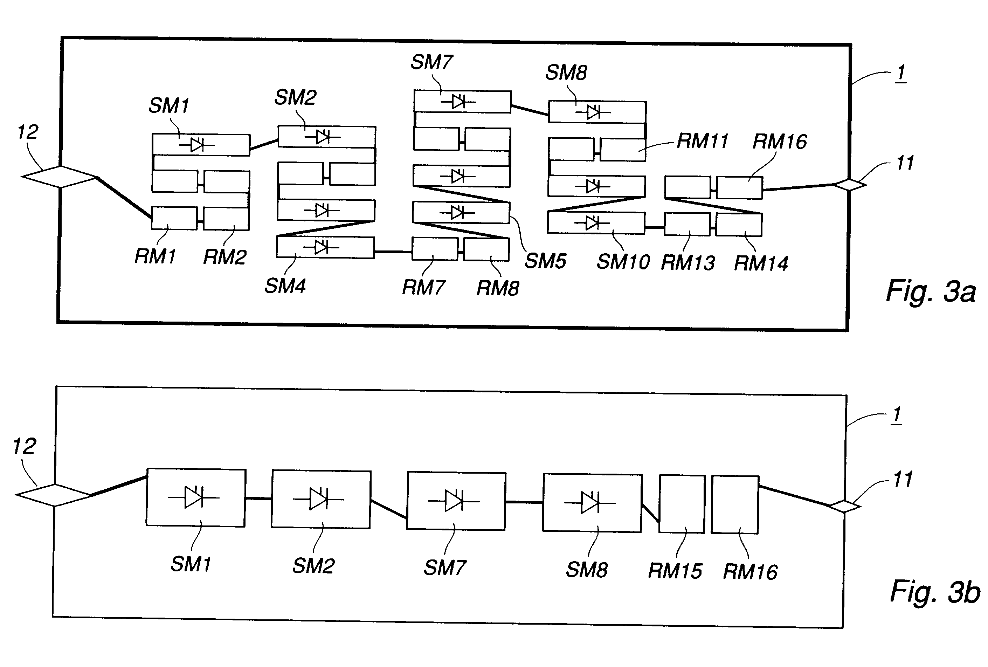

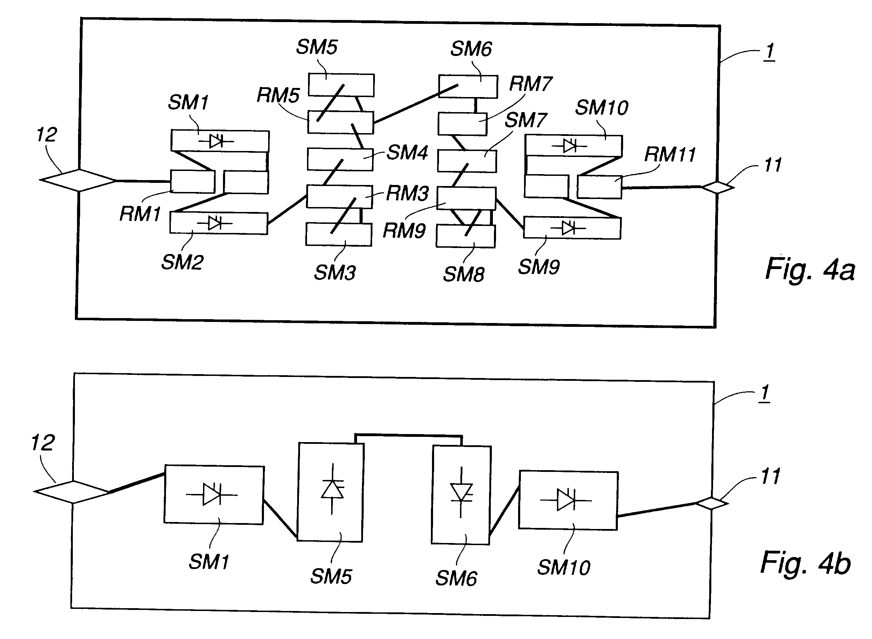

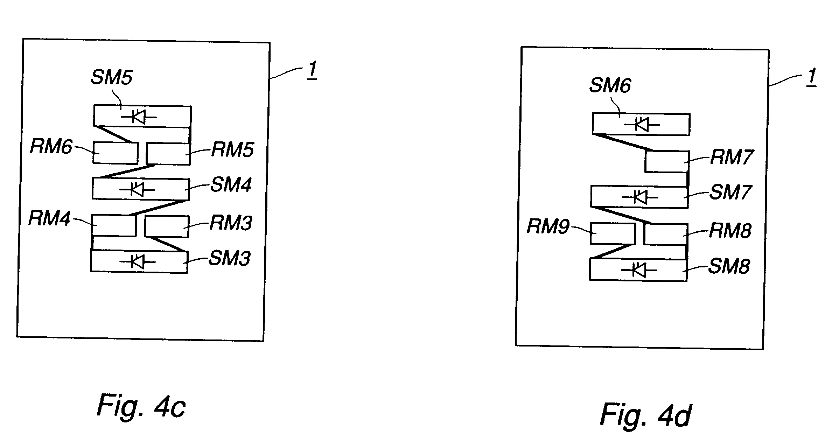

The invention will be described in more detail in the following with reference to the accompanying Figures 1-5. Figure 1 shows a valve means according to the invention in which the height of the semiconductor valve decreases from the first part towards the second part, and wherein Figure 1a shows the means seen from the side and Figure 1b shows the means seen from above. Figure 2 shows another embodiment of a valve means according to the invention in which both the height and the width of the semiconductor valve decrease from the first part towards the second part, and wherein Figure 2a shows the means seen from the side, Figure 2b shows the means seen from above, Figure 2c shows the means seen from that side where the potential difference is greatest, and Figure 2d is a oblique view of the means. Figure 3 shows a symmetrically constructed valve means according to the invention in which the height of the semiconductor valve is greatest at the centre and decreases towards both ends. Figure 3a shows the means seen from the side and Figure 3b shows the means seen from above. Figure 4 shows an embodiment of a symmetrically constructed means according to the invention, in which both the width and the height of the semiconductor valve are greatest at the centre of the means and decrease towards both ends. Figure 4a shows the means seen from the side and Figure 4b shows the means seen from above. Figures 4c and 4d show two of the valve's module stacks seen from the lefthand and righthand ends of the valve shown in Figure 4a. Figure 5 shows a circuit diagram of a six-pulse bridge with valve means according to the invention.

### DESCRIPTION OF THE PREFERRED EMBODIMENTS

Figure 1a shows an embodiment of a thyristor valve means according to the invention, seen from the side, and Figure 1b shows the same means seen from above. The means may, for example, consist of one of the six valves of a three-phase six-pulse bridge of the kind shown in Figure 5, and then one of the three upper valves in Figure 5. The semiconductor valve itself consists of the 10 thyristor modules SM1 - SM10, wherein each module in a manner known per se comprises a plurality of, for example six, series-connected thyristors with voltage-divider impedances and control equipment. The thyristor modules approximately have the shape of flat, elongated slabs.

As shown in Figure 1, a reactor module, RM1 - RM9, is arranged in the immediate extension of each of the thyristor modules SM1 - SM9, whereas two reactor modules, RM10 - RM11, are each arranged at an end of the thyristor module SM10.

The modules are electrically series-connected to each other by means of the conductors shown in thick lines. This series connection comprises, between each pair of thyristor modules and at the ends of the series connection, the reactor modules RM1 - RM11. The latter are inductors for limiting the rate of change of the current through the thyristors.

The valve means has an enclosure in the form of an elongated parallelepipedic metal housing 1. This may, for example, be designed and erected insulated from ground in the manner shown in the above-mentioned international patent application WO 93/17488. As shown in the figure, the housing 1 is arranged with its longitudinal direction horizontally and is intended to be erected with this orientation. In its shorter walls, the housing has bushings 11 and 12 for electrical connection of the semiconductor valve, that is, the bushings constitute the two main terminals of the semiconductor valve. Thyristor and reactor modules are mounted in the housing 1 with the aid of support devices (not shown) of insulating material. Outside the housing 1, the semiconductor valve is electrically connected to the housing with the aid of an electrical connection (not shown). The valve in the righthand end of the figure therefore lies at the same potential as the housing. Therefore, the bushing 11 need not, in principle, have any electrical insulation capability. At the lefthand end of the valve in the figure, however, the potential difference between the valve and the housing is equal to the valve voltage. Therefore, the bushing 12 is designed with an insulation capability which is sufficient for this voltage.

The "first part" LV of the semiconductor valve, where the potential difference between the valve and the enclosure is lowest, is located to the right in the figure and its "second part" HV, where the potential difference is highest, is located to the left in the figure. Thus, the main direction of the semiconductor valve in the shown example is horizontal and coincides with the longitudinal direction of the valve, which in this case is elongated, and the longitudinal direction of the valve is parallel to the longitudinal direction of the metal housing 1.

The housing 1 may also contain additional devices, for example surge arresters for protection of the thyristor valve against overvoltages. Such a surge arrester is suitably arranged in the manner described in WO 93/17488.

Lines and connections for control and measurement signals and for cooling and insulating agents are omitted from the figures for the sake of clarity. Also these components may, for example, be designed in the manner described in WO 93/17488.

The potential difference between the thyristor valve and the housing, occurring during operation, is zero at the low-voltage end LV of the valve, which end is electrically connected to the housing, and it increases successively along the valve in a direction towards the high-voltage end HV of the valve, where it is greatest. The valve is designed such that its height is greatest at the low-voltage end and gradually decreases towards the high-voltage end. This is achieved by arranging, nearest the low-voltage end, five layers of thyristor modules, SM6 - SM10, with associated reactor modules one above the other. Next there follows, in a direction towards the high-voltage end of the valve, a section with three thyristor modules, SM3 - SM5, in the vertical direction, and nearest the high-voltage end the valve has two thyristor modules, SM1 - SM2, in the vertical direction. In this way, a tapering shape is imparted to the valve along the horizontal main direction of the valve from the low-voltage end towards the high-voltage end. This results in the distance in the vertical direction between the outer contour of the valve and the housing - the flashover distance - increasing from the low-voltage end towards the high-voltage end in a manner which corresponds to the increasing potential difference between the valve and the housing. This, in turn, means that the height of the housing may be considerably reduced compared with a corresponding prior art valve, in which the width and the height of the valve are approximately constant along the main direction of the valve.

Preferably, the valve module stacks are not placed in the centre of the housing in the vertical direction, but they are placed in view of their position in the series connection, that is, in view of their individual potential relative to the housing. As schematically shown in Figure 1a, the modules are placed in such a way in the vertical direction that the vertical distances d1, d2 ... d6 successively increase. The distance d1 thus corresponds to one single "module voltage drop", whereas the distance d2 corresponds to five such voltage drops, the distance d3 to six voltage drops, and so on. In this way, it is possible to achieve a situation where, with a good approximation, the actual flashover distance between the valve and the housing will not at any point along the valve exceed the distance required at the potential difference prevailing at the point in question. This allows the dimensions of the housing - in this case in the vertical direction - to be made as small as possible. This makes it possible to accommodate valves for higher voltages than what has hitherto been possible within the loading-gauges which limit the transport dimensions.

Figure 2 shows a valve means according to another embodiment of the invention. Figure 2a shows the valve means seen from the side, Figure 2b the valve means seen from above, Figure 2c the valve means seen from its lefthand short side in Figure 2a, and Figure 2d is an oblique view of the valve means. In the same way as the valve means 10 shown in Figure 1, it has 10 thyristor modules SM1 - SM10 and 11 reactor modules RM1 - RM11. In the same way as in Figure 1, the thyristor modules SM1 and SM2 with the associated reactor modules are placed one above the other at the high-voltage end of the valve and with their longitudinal axes in the main direction/longitudinal direction of the valve. The other thyristor modules SM3 - SM10 are rotated through 90° and have their longitudinal axes perpendicular to the main direction of the valve. They are arranged in two stacks with four thyristor modules one above the other in each stack. Between the two stacks, the reactor modules RM3 - RM10 are arranged in four layers one above the other and with two modules in each layer. The reactor module RMll is placed adjacent to the lowermost layer of reactor modules. The modules are electrically series-connected in the order RM11, SM10, RM10, SM9, RM9, ... SM4, RM4, SM3, RM3, SM2, RM2, SM1, RM1. The potential difference between the valve and the housing increases in the same order. Also in this embodiment, the way in which the potential difference increases along the valve from the low-voltage end towards the high-voltage end has been taken into consideration when placing the modules. Thus, both the thyristor module stacks and the intermediate reactor module stack are arranged at a considerably smaller distance to the bottom of the housing than to its upper surface. The reactor module RM11, one connection of which is connected at the potential of the housing, is placed very close to one side wall of the housing.

The valve means shown in Figure 2 thus has an extent which decreases along the main direction of the valve, both in the vertical and in the lateral direction, that is, in two directions perpendicular to each other and to the main direction/longitudinal direction of the valve. This allows the dimensions of the housing to be further reduced compared with the valve shown in Figure 1, and especially the length of the housing can be considerably reduced.

The valve means shown in Figure 2 differs from that shown in Figure 1 by its anode side being electrically connected to the enclosure. In this way, it is suited for use as one of the three lower valves in Figure 5.

In the valve means according to the invention, described above with reference to Figures 1 and 2, the extent of the semiconductor valve in the vertical direction, that is, in a direction perpendicular to the horizontal main direction of the valve, is greatest at that part (the "first part") where the potential difference between the valve and the enclosure is lowest, and smallest at that part (the "second part") where the potential difference between the valve and the enclosure is lowest, that is, the extent of the valve in the vertical direction decreases from the first part towards the second part along substantially the whole extent of the valve in the main direction. Because of the modular design of the valve, this decrease is discontinuous.

In the valve means shown in Figure 1, the extent of the valve decreases only in the vertical direction, whereas the width of the valve is, in principle, constant - apart from variations caused by the modular design. In the valve means shown in Figure 2, the extent of the valve decreases both in the vertical and in the lateral direction, that is, its extent in two directions perpendicular to each other and to the main direction decreases from the first part towards the second part, and this along substantially the whole extent of the semiconductor valve in the main direction.

Figure 3 shows an alternative embodiment of a valve means according to the invention. Figure 3a shows the valve means seen from the side and Figure 3b the valve means seen from above. The design of this valve means is determined by the fact that it is intended to serve as a spare valve for an HVDC converter. As shown in Figure 5, which shows a six-pulse bridge with the thyristor valves V1 - V6, included in such a converter, the upper valves V1, V3, V5 in the figure have their cathodes connected to the enclosure, whereas the valves V2, V4, V6 have their anodes connected to the enclosure. This makes possible the erection of the three upper valves of the bridge on a common insulated platform, since their enclosures are at the same potential. In the same way, the three lower valves may be erected on a common platform. This makes possible savings both with regard to space and costs. Keeping spare valves for the converter would require two spare valves, one of the upper type in Figure 5 and one of the lower type. The valve means shown in Figure 3 is designed to be able to serve as a spare valve both for the upper and the lower valve type in Figure 5. The semiconductor valve has its largest vertical extent in the middle, and its height decreases towards both ends. It has 10 thyristor modules SM1 - SM10 and 16 reactor modules RM1 - RM16. The modules are arranged in five stacks with five layers of modules in the middle stack, four layers in the stacks located on both sides of the middle stack, and with two and three layers, respectively, in the outermost stacks. In the valve means shown in Figure 3, the low-voltage bushing 11 lies to the right and the high-voltage bushing 12 to the left in the figure. This means that the valve means in the shown condition may be used instead of the upper valves shown in Figure 5. However, the valve means is designed such that the low-voltage and high-voltage bushings may change places, and since the valve means is substantially symmetrically constructed, it may after such a change serve as any one of the lower valves in Figure 5. Thus, when using a valve means of the kind shown in Figure 3, only one single spare valve is required for a converter. Because the height of the semiconductor valve varies along its longitudinal direction, the dimensions of the valve means will be smaller than if the semiconductor valve has a constant height.

Figure 4 shows an example of an alternative embodiment of a valve means according to the invention, which is intended as a spare valve for an HVDC converter. It has 10 thyristor modules SM1 - SM10 and 11 reactor modules RM1 - RM11. Figure 4a shows the valve means seen from the side, and Figure 4b the valve means seen from above. Figure 4c shows the module stack with the thyristor modules SM3 - SM5 seen from the left in Figure 4a, and Figure 4d shows, in similar manner, the module stack with the thyristor modules SM6 - SM8, seen from the right in Figure 4a. As will be clear from the figures, the thyristor modules SM1, SM2, SM9, SM10 are placed with their longitudinal axes in the longitudinal direction of the valve, whereas the modules SM3-SM8 are rotated through 90° in relation to the longitudinal direction of the valve. This results in a reduction of the total length of the valve compared with the valve shown in Figure 3.

Figure 5 has already essentially been referred to above. The figure shows a three-phase six-pulse thyristor bridge for use, for example, in an HVDC converter. It has the a.c. connections R, S, T and the d.c. connections DC+ and DC-. Its six thyristor valves V1 - V6 are designed according to the invention. The enclosure of each valve is connected to one of the main terminals of the valve, for the upper valves V1, V3, V5 to the cathode terminals of the valves, and for the lower valves V2, V4, V6 to the anode terminals of the valves. In this way, the housings of the three upper valves will be located at the same potential and may be arranged on the same insulated platform or stand. Likewise, the three lower valves will be located at mutually the same potential and may be arranged on a common second platform.

In the embodiments of the invention described above, the change in dimension in one of the directions perpendicular to the main direction of the valve, namely in the vertical direction, is achieved by the number of modules above one another, that is, along one another in a vertical direction, decreasing from the first part towards the second part. In the other of the directions perpendicular to the main direction of the valve (the lateral direction), the change in dimension is achieved in another way, namely by arranging the elongated valve modules at the first part with their longitudinal directions perpendicular to the main direction of the valve and at the second part with their longitudinal directions parallel to the main direction of the valve. Alternatively, valve modules may, of course, be arranged in other ways to achieve the desired variation in dimensions. Thus, for example, the valve at its "first part" may consist of a plurality of modules both above one another and abreast of one another, the number of modules both in the vertical and lateral directions being reduced in a direction towards the "second part" of the valve.

In the embodiments of the invention described above, the semiconductor valve arranged in the valve means is an entire electric valve, for example V1 in Figure 5. However, as mentioned by way of introduction, the semiconductor valve of each valve means may alternatively consist of a part of a valve, for example a half-valve.

Alternatively, a valve means according to the invention may contain parts of valves which are electrically connected to each other, for example the lower half of the valve V1 in Figure 5 and the upper half of the valve V4. The enclosure is then preferably connected to the connection point of both valve halves, that is, to the phase terminal R. This point then becomes the common "first part" of the two valve halves and is arranged at the centre of the longitudinal axis of the semiconductor valve, and the high-voltage bushings are arranged at opposite ends of the enclosure. According to the invention, the valve halves are then designed such that their dimensions in the vertical and/or lateral direction (the valve means is assumed to have a horizontal main direction) decrease in both directions from the mid-point towards the "second parts" of the semiconductor valve which are situated at the opposite ends of the enclosure.

Alternatively, a valve means according to the invention may contain several valves arranged in one common enclosure. Thus, for example, the three valves connected to the same d.c. terminal, for example the valves V1, V3, V5 in Figure 5, may be arranged adjacent to each other in a common metal housing, which is then electrically connected to the cathode ends of the valves. In order to reduce the transport dimensions, such a housing may suitably be made divisible into three parts, one part per valve. Also in a valve means of this kind, the invention offers considerable advantages in the form of reduced dimensions.

The valve means described above are elongated, that is, the enclosure and the actual semiconductor valve have a considerably larger extent along the main direction of the valve, which constitutes the longitudinal axis, than perpendicularly to this direction. However, the invention may also be applied to valve means which do not have any definite longitudinal axis.

The valves described above have horizontal main directions and longitudinal axes, but the invention may be applied also to non-horizontally erected valves.

The preferred embodiments of valve means according to the invention described above have enclosures in the form of paralellelepipedic enclosures. However, within the scope of the invention the enclosures may be given a different shape. For example, the desired variation of the flashover distance along the valve may be achieved by making the actual semiconductor valve according to the invention tapering from the low-voltage end towards the high-voltage end and by giving the enclosure dimensions, perpendicularly to the main direction of the semiconductor valve, which increase from the low-voltage end towards the high-voltage end.

In the valve means described above, the two bushings are arranged in the two opposed shorter walls of the enclosure. Alternatively, however, one of or both of the bushings may be arranged in any of the side walls of the enclosure, or in its upper and lower wall. A suitable embodiment may be, as shown in WO 93/17488, to arrange the high-voltage bushing in the upper wall of the enclosure.

In the valve means according to the invention described above, the enclosure is electrically connected to one end of the semiconductor valve, the low-voltage end of which will then be located at the same potential as the enclosure. However, the invention does not require that the low-voltage end of the valve is located at exactly the same potential as the enclosure. The low-voltage end and the enclosure may, for example, be connected through some form of impedance element which causes the potential difference between the valve and the enclosure to be lower at the low-voltage end than at the high-voltage end thereof. Such an impedance element may, for example, consist of a surge arrester with a knee voltage which is considerably lower than the maximum valve voltage.

## Claims

1. An enclosed gas-insulated valve means for high voltage and high power, preferably for an installation for power transmission by means of high-voltage direct current, wherein
- the valve means comprises an enclosure (1) of electrically conducting material and a semiconductor valve (SM1-SM10, RM1-RM11) arranged in the enclosure,
- the semiconductor valve has a plurality of electrically series-connected power semiconductor elements (SM1-SM10) and a first (11) and a second (12) electric main terminal,
- the main terminals are arranged at first (LV) and second (HV), mutually opposite parts of the semiconductor valve,
- the direction between the first and second parts constitutes the main direction of the semiconductor valve, and
- the valve means is adapted for a maximum potential difference, occurring during operation, between the semiconductor valve and the enclosure which is lower at the first part (LV) than at the second part (HV),
**characterized** in that the extent of the semiconductor valve in at least one direction perpendicular to the main direction decreases from the first part (LV) towards the second part (HV) along at least part of the extent of the semiconductor valve in the main direction.

2. A valve means according to claim 1, **characterized** in that the enclosure (1) is substantially parallelepipedic.

3. A valve means according to claim 1 or 2, **characterized** in that the enclosure (1) is elongated.

4. A valve means according to claim 3, **characterized** in that the semiconductor valve (SM1-SM10, RM1-RM9) is elongated, has a longitudinal direction which substantially coincides with its main direction, and is arranged with its longitudinal direction substantially parallel to the longitudinal direction of the enclosure.

5. A valve means according to claim 4, **characterized** in that it is arranged for erection with its longitudinal direction substantially horizontally.

6. A valve means according to any of the preceding claims, **characterized** in that the extent of the semiconductor valve in two directions perpendicular to each other and to the main direction decreases from the first part towards the second part.

7. A valve means according to any of the preceding claims, **characterized** in that the extent of the semiconductor valve in at least one direction, which is perpendicular to the main direction, decreases from the first part towards the second part along substantially the whole extent of the semiconductor valve in the main direction.

8. A valve means according to any of claims 1-6, **characterized** in that the extent of the semiconductor valve in at least one direction perpendicular to the main direction decreases from the first part towards the second part only along a part of the semiconductor valve located nearest to the second part.

9. A valve means according to claim 8, **characterized** in that the extent of the semiconductor valve in at least one direction perpendicular to the main direction increases from the first part towards the second part along a part of the semiconductor valve located nearest to the first part.

10. A valve means according to claim 9, **characterized** in that the extent of the semiconductor valve in the direction perpendicular to the main direction is greatest at the centre of the semiconductor valve and smallest at the first part and the second part.

11. A valve means according to claim 10, **characterized** in that the semiconductor valve is substantially symmetrically constructed and has substantially the same extent in said direction perpendicular to the main direction at the second part as at the first part.

12. A valve means according to any of the preceding claims, in which the semiconductor valve is built up of a plurality of electrically series-connected modules, at least some of which comprising semiconductor elements, **characterized** in that at least part of the semiconductor valve consists of modules arranged one after the other in a transverse direction perpendicular to the main direction, the number of modules arranged one after the other in the transverse direction decreasing from the first part towards the second part along at least part of the semiconductor valve.

13. A valve means according to any of the preceding claims, in which the semiconductor valve is built up of a plurality of electrically series-connected modules (SM1-SM10, RM1-RM11), at least some of which (SM1-SM10) comprising semiconductor elements, and in which at least certain modules are elongated, **characterized** in that the semiconductor valve has a first group of elongated modules (SM3-SM10) which are arranged nearer the first part and which are arranged with their longitudinal axes substantially perpendicular to the main direction of the semiconductor valve, and a second group of elongated modules (SM1-SM2) which are arranged nearer the second part and which are arranged with their longitudinal axes substantially parallel to the main direction of the semiconductor valve.

14. A valve means according to any of the preceding claims, **characterized** in that the enclosure is made of metal.

## Patentansprüche

1. Gekapselte, gasisolierte Ventilanordnung für hohe Spannungen und große Leistungen, vorzugsweise für eine mit Hochspannungs-Gleichstrom arbeitende Kraftüberführungsinstallation, in der
- die Ventilanordnung eine Kapselung (1) aus elektrisch leitendem Material und ein in der Kapselung angeordnetes Halbleiterventil (SM1 bis SM10, RM1 bis RM11) umfaßt,
- das Halbleiterventil eine Reihe elektrisch in Serie geschalteter Halbleiterelemente (SM1 bis SM10) und einen ersten (11) und zweiten (12) elektrischen Hauptpol aufweist,
- die Hauptpole an erste (LV) und zweite (HV), einander gegenüberliegenden Teile des Halbleiterventil angeordnet sind,
- die Richtung zwischen den ersten und zweiten Teilcn die Hauptrichtung des Halbleiterventils bildet, und
- die Ventilanordnung während des Betriebes für größtmöglichen Spannungsunterschied zwischen dem Halbleiterventil und der Kapselung vorgesehen ist, der am ersten Teil (LV) geringer ist als am zweiten Teil (HV),
**dadurch gekennzeichnet,** daß die Ausdehnung des Halbleiterventiles in mindestens einer zur Hauptrichtung lotrechten Richtung vom ersten Teil (LV) zum zweiten Teil (HV) hin entlang zumindestens einem Teil der Ausdehnung des Halbleiterventiles in der Hauptrichtung abnimmt.

2. Ventilanordnung gemäß Patentanspruch 1, **dadurch gekennzeichnet**, daß die Kapselung (1) vorwiegend parallelepipedisch ist.

3. Ventilanordnung gemäß Patentanspruch 1 oder 2 , **dadurch gekennzeichnet**, daß die Kapselung (1) länglich ist.

4. Ventilanordnung gemäß Patentanspruch 3, **dadurch gekennzeichnet**, daß das Halbleiterventil (SM1 bis SM10, RM1 bis RM9) länglich ist, eine mit dessen Hauptrichtung im wesentlichen zusammenfallende Längsrichtung aufweist und mit seiner Längsrichtung im wesentlichen parallel zur Längsrichtung der Kapselung angeordnet ist.

5. Ventilanordnung gemäß Patentanspruch 4, **dadurch gekennzeichnet**, daß sie für ein Errichten mit einer im wesentlichen horizontalen Längsachse vorgesehen ist.

6. Ventilanordnung gemäß einem der vorhergehenden Patentansprüche, **dadurch gekennzeichnet,** daß die Ausdehnung des Halbleiterventiles in zwei zueinander und zur Hauptrichtung lotrechten Richtungen vom ersten Teil zum zweiten Teil hin abnimmt.

7. Ventilanordnung gemäß einem der vorhergehenden Patentansprüche, **dadurch gekennzeichnet,** daß die Ausdehnung des Halbleiterventiles in mindestens einer zur Hauptrichtung lotrechten Richtung vom ersten Teil zum zweiten Teil hin entlang im wesentlichen der ganzen Ausdehnung des Halbleiterventiles in der Hauptrichtung abnimmt.

8. Ventilanordnung gemäß einem der Patentansprüche 1 bis 6, **dadurch gekennzeichnet**, daß die Ausdehnung des Halbleiterventiles in mindestens einer zur Hauptrichtung lotrechten Richtung vom ersten Teil zum zweiten Teil hin nur entlang einem dem zweiten Teil zunächst liegenden Teil des Halbleiterventiles abnimmt.

9. Ventilanordnung gemäß Patentanspruch 8, **dadurch gekennzeichnet**, daß die Ausdehnung des Halbleiterventiles in mindestens einer zur Hauptrichtung lotrechten Richtung vom ersten Teil zum zweiten Teil hin entlang einem dem ersten Teil zunächst liegenden Teil des Halbleiterventiles zunimmt.

10. Ventilanordnung gemäß Patentanspruch 9, **dadurch gekennzeichnet**, daß die Ausdehnung des Halbleiterventiles in der zur Hauptrichtung lotrechten Richtung in der Mitte des Halbleiterventiles am größten und am ersten und zweiten Teil am kleinsten ist.

11. Ventilanordnung gemäß Patentanspruch 10, **dadurch gekennzeichnet**, daß das Halbleiterventil im wesentlichen symmetrisch gestaltet ist und im wesentlichen dieselbe Ausdehnung in diese zur Hauptrichtung lotrechten Richtung am zweiten wie am ersten Teil aufweist.

12. Ventilanordnung gemäß einem der vorhergehenden Patentansprüche, in der das Halbleiterventil aus einer Reihe elektrisch seriengeschalteter Module besteht, von denen zumindestens einige Halbleiterelemente aufweisen, **dadurch gekennzeichnet**, daß zumindestens ein Teil des Halbleiterventiles aus hintereinander in einer zur Hauptrichtung lotrechten Querrichtung angeordneten Modulen besteht, die vom ersten Teil zum zweiten Teil hin entlang zumindestens einem Teil des Halbleiterventiles abnimmt.

13. Ventilanordnung gemäß einem der vorhergehenden Patentansprüche, in der das Halbleiterventil aus einer Reihe elektrisch seriengeschalteter Module (SM1 bis SM10, RM1 bis RM11) besteht, von denen mindestens einige (SM1 bis SM10) Halbleiterelmente umfassen, und in der mindestens gewisse Module länglich sind, **dadurch gekennzeichnet**, daß das Halbleiterventil eine erste Gruppe länglicher Module (SM3 bis SM10) aufweist, die näher dem ersten Teil und mit ihren Längsachsen im wesentlichen lotrecht zur Hauptrichtung des Halbleiterventiles liegen und einer zweiten Gruppe länglicher Module (SM1 bis SM2) aufweist, die näher dem zweiten Teil und mit ihren Längsachsen im wesentlichen parallel zur Hauptrichtung des Halbleiterventiles angeordnet sind.

14. Ventilanordnung gemäß einem der vorhergehenden Patentansprüche, **dadurch gekennzeichnet**, daß die Kapselung aus Metall besteht.

## Revendications

1. Tube électronique à isolation par un gaz contenu dans une enceinte pour une haute tension et une puissance élevée, de préférence pour une installation destinée à la transmission d'énergie électrique au moyen d'un courant continu à haute tension, dans lequel:
- le tube électronique comprend une enceinte (1) constituée d'un matériau électriquement conducteur et un tube à semi-conducteur (SM1-SM10,RM1-RM11) disposé dans l'enceinte,
- le tube à semi-conducteur a une pluralité d'éléments (SM1-SM10) semi-conducteurs de puissance connectés en série et des première (11) et seconde (12) bornes électriques principales,
- les bornes principales sont disposées sur des première (LV) et seconde (HV) parties mutuellement opposées du tube à semi-conducteur,
- la direction entre les première et seconde parties constitue la direction principale du tube à semi-conducteur, et
- le tube électronique est adapté pour une différence de potentiel maximale, se produisant pendant le fonctionnement, entre le tube à semi-conducteur et l'enceinte, qui est plus faible dans la première partie (LV) que dans la seconde partie (HV),
caractérisé en ce que l'étendue du tube à semi-conducteur, dans au moins une direction perpendiculaire à la direction principale, décroît de la première partie (LV) vers la seconde partie (HV) le long d'au moins une partie de l'étendue du tube à semi-conducteur, dans la direction principale.

2. Tube électronique selon la revendication 1, caractérisé en ce que l'enceinte (1) est sensiblement parallélépipédique.

3. Tube électronique selon la revendication 1 ou 2, caractérisé en ce que l'enceinte (1) est oblongue.

4. Tube électronique selon la revendication 3, caractérisé en ce que le tube à semi-conducteur (SM1-SM10, RM1-RM9) est oblong, a une direction longitudinale qui coïncide sensiblement avec sa direction principale, et est agencé de telle façon que sa direction longitudinale soit sensiblement parallèle à la direction longitudinale de l'enceinte.

5. Tube électronique selon la revendication 4, caractérisé en ce qu'il est agencé pour être monté de telle façon que sa direction longitudinale soit sensiblement horizontale.

6. Tube électronique selon l'une quelconque des revendications précédentes, caractérisé en ce que l'étendue du tube à semi-conducteur dans deux directions perpendiculaires l'une à l'autre et à la direction principale décroît de la première partie vers la seconde partie.

7. Tube électronique selon l'une quelconque des revendications précédentes, caractérisé en ce que l'étendue du tube à semi-conducteur dans au moins une direction, qui est perpendiculaire à la direction principale, décroît de la première partie vers la seconde partie sur pratiquement toute l'étendue du tube à semi-conducteur, dans la direction principale.

8. Tube électronique selon l'une quelconque des revendications 1 à 6, caractérisé en ce que l'étendue du tube à semi-conducteur, dans au moins une direction perpendiculaire à la direction principale, ne décroît de la première partie vers la seconde partie que sur une partie du tube à semi-conducteur qui se trouve le plus prés de la seconde partie.

9. Tube électronique selon la revendication 8, caractérisé en ce que l'étendue du tube à semi-conducteur dans au moins une direction perpendiculaire à la direction principale, croît de la première partie vers la seconde partie le long d'une partie du tube à semi-conducteur qui se trouve le plus près de la première partie.

10. Tube électronique selon la revendication 9, caractérisé en ce que l'étendue du tube à semi-conducteur, dans la direction perpendiculaire à la direction principale, est la plus grande au centre du tube à semi-conducteur et la plus faible dans la première partie et la seconde partie.

11. Tube électronique selon la revendication 10, caractérisé en ce que le tube à semi-conducteur est réalisé de façon sensiblement symétrique et a une étendue, dans la direction perpendiculaire à la direction principale. sensiblement identique dans la seconde partie et dans la première partie.

12. Tube électronique selon l'une quelconque des revendications précédentes, dans lequel le tube à semi-conducteur est constitué d'une pluralité de modules connectés électriquement en série, dont au moins certains comprennent des éléments semi-conducteurs, caractérisé en ce qu'au moins une partie du tube à semi-conducteur est constituée de modules agencés l'un après l'autre dans une direction transversale perpendiculaire à la direction principale, le nombre de modules agencés l'un après l'autre dans la direction transversale décroissant de la première partie vers la seconde partie le long d'au moins une partie du tube à semi-conducteur.

13. Tube électronique selon l'une quelconque des revendications précédentes, dans lequel le tube à semi-conducteur est constitué d'une pluralité de modules (SM1-SM10, RM1-RM11) connectés électriquement en série, dont au moins certains (SM1-SM10) comprennent des éléments semi-conducteurs et dans lequel au moins certains modules sont oblongs, caractérisé en ce que le tube à semi-conducteur comporte un premier groupe de modules oblongs (SM3-SM10) qui sont agencés plus près de la première partie et qui sont agencés de telle façon que leurs axes longitudinaux soient sensiblement perpendiculaires à la direction principale du tube à semi-conducteur, et un second groupe de modules (SM1-SM2) oblongs qui sont agencés plus près de la seconde partie et qui sont agencés de telle façon que leurs axes longitudinaux soient sensiblement parallèles à la direction principale du tube à semi-conducteur.

14. Tube électronique selon l'une quelconque des revendications précédentes, caractérisé en ce que l'enceinte est faite de métal.
